(19) Europäisches Patentamt / European Patent Office / Office européen des brevets

(11) **EP 1 622 261 B1**

(12) **EUROPEAN PATENT SPECIFICATION**

(45) Date of publication and mention
of the grant of the patent:
**26.03.2008 Bulletin 2008/13**

(51) Int Cl.:
*H03F 3/50* (2006.01)   *H03F 3/345* (2006.01)
*H03F 3/72* (2006.01)

(21) Application number: **05014984.8**

(22) Date of filing: **11.07.2005**

(54) **Source follower amplifier device and camera using same**

Quellenfolger-Verstärkeranordnung und Kamera, welche diese verwendet

Dispositif amplificateur source-suiveur et caméra utilisant ce dispositif

(84) Designated Contracting States:
FR GB

(30) Priority: **29.07.2004 JP 2004221686**

(43) Date of publication of application:
**01.02.2006 Bulletin 2006/05**

(73) Proprietor: **MATSUSHITA ELECTRIC INDUSTRIAL CO., LTD**
**Kadoma-shi, Osaka 571-8501 (JP)**

(72) Inventors:
• **Nagayoshi, Ryoichi**
**Nishinomiya-shi**
**Hyogo 662-0076 (JP)**

• **Mutoh, Nobuhiko**
**Suita-shi**
**Osaka 565-0824 (JP)**

(74) Representative: **Pautex Schneider, Nicole Véronique et al**
**Novagraaf International SA**
**25, Avenue du Pailly**
**1220 Les Avanchets - Geneva (CH)**

(56) References cited:
**US-A- 5 905 256**

**Description**

**BACKGROUND OF THE INVENTION**

**(1) Field of the Invention**

The present invention relates to a semiconductor device having a source-follower amplifier which is suitable as an amplifier device in a solid-state image sensor and the like, and a camera using the semiconductor device.

**(2) Description of the Related Art**

In recent years, portable terminal devices such as a cellular telephone equipped with digital cameras, which uses charge-coupled device (CCD) type or metal-oxide semiconductor (MOS) type image sensors, are available, and the digital camera enables to capture still images and moving images. In capturing the moving images, a frequency of a pixel signal is required to be high in order to consecutively capture a plurality of images. In capturing the still images, on the other hand, the frequency of the pixel signal may be low. In the case where, for example, a drive frequency is variable in a single CCD image sensor, it is desirable to minimize a frequency bandwidth of a source-follower amplifier in terms of noise reduction of the amplifier and power consumption reduction. Thus, conventional semiconductor device have been conceived to vary a bias voltage applied to gate electrodes of load transistors in latter stages including a final stage thereby varying conductance of the load transistors to adjust the frequency bandwidth of the pixel signal (as disclosed in Japanese Patent No. 2795314 publication; pages 1-10; FIG. 5, for example).

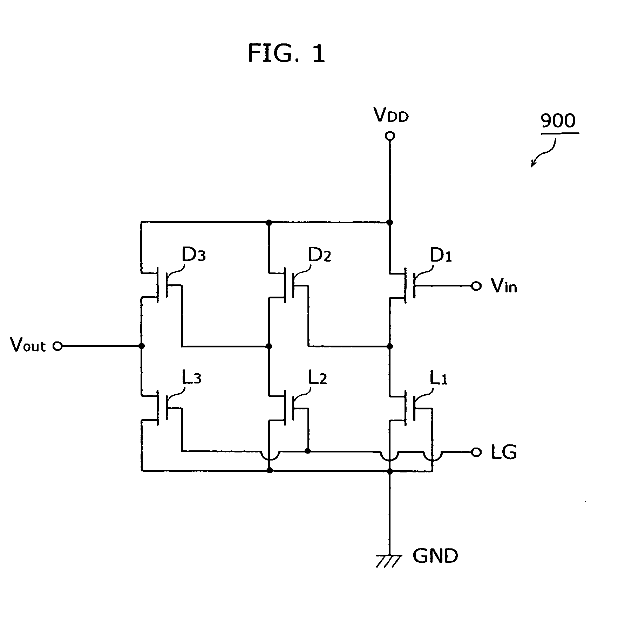

FIG.1 is a circuit diagram showing a conventional semiconductor device.
Referring to FIG. 1, the conventional semiconductor device 900 is composed of three stages with source-follower amplifiers in respective stages. A source-follower amplifier in an initial stage includes a driver transistor D1 and a load transistor L1, a source-follower amplifier in a second stage (one stage before the final stage) includes a driver transistor D2 and a load transistor L2, and a source-follower amplifier in a third stage (final stage) includes a driver transistor D3 and a load transistor L3. Note that the driver transistors D1, D2 and D3, and the load transistors L1, L2 and L3 are using MOS transistors.
Drains of the driver transistors D1, D2 and D3 in the source-follower amplifiers in the respective stages are connected to a power supply terminal VDD respectively. Sources of the load transistors L1, L2 and L3 in the source-follower amplifiers in the respective stages are connected to ground terminals GND respectively.
The source of the driver transistor D1 in the first-stage source-follower amplifier is connected to the drain of the load transistor L1 and also to a gate of the driver transistor D2 in the second-stage source-follower amplifier. A gate of the driver transistor D1 is connected to an input terminal Vin to which pixel signal is inputted in capturing moving images and still images.
The source of the driver transistor D2 in the second-stage source-follower amplifier is connected to the drain of the load transistor L2, and also to a gate of the driver transistor D3 in the final-stage source-follower amplifier.
The source of the driver transistor D3 in the final-stage source-follower amplifier is connected to the drain of the load transistor L3, and also to an output terminal Vout from which the pixel signal is outputted to the outside.
Furthermore, a gate of the load transistor L1 in the initial-stage source-follower amplifier is connected to the ground terminal GND, while gates of the load transistors L2 and L3 in the source-follower amplifiers in the second and final stages are applied with a same amount of bias voltage LG that can vary the frequency to achieve a suitable frequency bandwidth of a signal inputted to the input terminal Vin..
Using the semiconductor device 900 configured as above, an amount of power consumption and the frequency bandwidth of the signal can be changed consecutively by changing bias voltage LG.
Here, in the source-follower amplifier in a stage, a transconductance gmD of the driver transistor D is determined by the following equation (1), wherein a mobility is $\mu$D, a gate width is WD, a gate length is LD, a gate capacitance is CoxD, a threshold voltage is VtD, an input voltage is Vi, and an output voltage is Vo, regarding the driver transistor D:

$$gmD = \mu D*CoxD*(WD/LD)*(Vi-Vo-VtD). \qquad (1)$$

Further, a bandwidth ft defined as a frequency, whose amplification factor is lowered by 3dB than an amplification factor of a direct current component, is determined by the following equation (2), wherein a load capacitance of the signal outputted from the source-follower amplifier is C:

$$ft = 2*n*gmD/C. \qquad (2)$$

Note that the load capacitance C includes an input capacitance of the driver transistor in the next stage, a wiring capacitance, and the like. Note also that the source-follower amplifier in the final stage is connected to an external circuit, and thereby its load capacitance is increased and is greater than load capacitances in other stages.

Furthermore, a current consumption I depends on the load transistor L serving as a constant current source, and is determined by the following equation (3), wherein a mobility is $\mu L$, a gate width is WL, a gate length is LL, a gate capacitance is CoxL, a threshold voltage is VtL, and a voltage between gate and source is VgsL, regarding the load transistor L:

$$I = (1/2)*\mu L*CoxL*(WL/LL)*(VgsL-VtL)^2. \qquad (3)$$

Still further, a gain G is determined by the following equation (4), wherein a transconductance of a back gate of the driver transistor D is gmb, a conductance of the driver transistor D is gdsD, and a conductance of the load transistor L is gdsL:

$$G = gmD/(gmD+gmb+gdsD+gdsL). \qquad (4)$$

Further, the gain G is also determined by the following equation (5), wherein the equations (1) and (3) are assigned to the equation (4), and a coefficient of WD in the denominator is "a", a coefficient of WL in the denominator is "b" and a coefficient of WD in numerator is "c":

$$G = (c*WD)/(a*WD+b*WL). \qquad (5)$$

Note that an operating point of the output voltage Vo of the source-follower amplifier depends on a resistance ratio between the driver transistor D and the load transistor L.

In general, the source-follower amplifiers are used in a multi-stage structure in a signal outputting unit to reduce an output impedance.

In such multi-stage source-follower amplifiers, since the load capacitances are increased stage by stage toward the latter stages, the WD and LD of the driver transistors D are expanded gradually from the initial-stage to the final-stage thereby increasing the gmD in the equation (1), which adjusts to make the frequency bandwidth by the equation (2) appropriately constant (constant-bandwidth technology).

However, in the above case, in the case where only WD and LD of the driver transistor D are expanded, the operating points are shifted and thereby WL and LL of the load transistor are increased as well. As a result the current consumption is greater than the current consumption calculated by the equation (3), and it should be noted that the current consumption is greater in the latter stage.

Thus, when still images are captured, it is efficient to save unnecessary electric currents in the latter stages.

Moreover, there is another example of the method for adjusting the current consumptions and the frequency bandwidths by varying gate bias voltages applied to the load transistors in the latter stages in order to reduce current consumption.

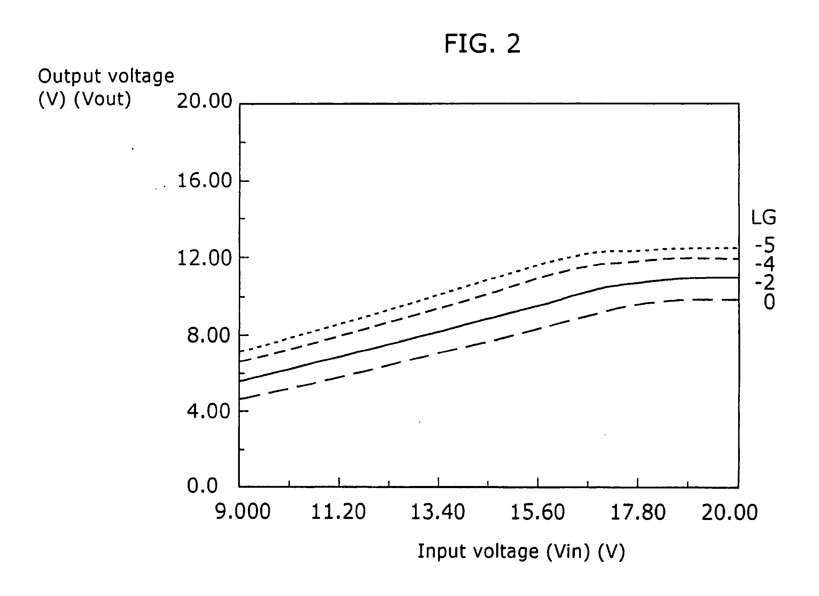

The equation (3) shows that the current consumption can be changed by the gate bias voltage. The equation (2) shows that the frequency bandwidth can be changed by varying the current consumption thereby varying the operating point Vo and eventually varying the transconductance. In this case, both the gain and the operating point are changed, and the amount of the changes is variable within an acceptable range. Since the amount of the changes are small as described further below with reference to FIGS. 2 to 5, and the gain and the operating point can vary within a substantially wide range. Furthermore, regarding linearity of input-output characteristics, a linear region of the input-output characteristics is reduced when the operating point is too low or too high, but the operating point of the multi-stage amplifiers is generally getting lower gradually toward the latter stages, when voltages applied to the gates of the load transistors in the latter stages can vary, it does not need to consider a limit of a linearity whose operating point is high. A limit of a linearity whose operating point is low can vary within a substantially wide range since the change of the operating point is small as described above. Therefore, the three-stage source-follower amplifiers, in which the frequency bandwidths is reduced, enable to reduce the amount of the current consumption comparing to the amount of the current consumption in the two-stage source-follower amplifiers.

This results from that in the three-stage source-follower amplifiers, since the load capacitance in the second stage, which is not the final stage, decreases, the current consumption can be reduced comparing to the case where the second stage is the final stage. Because the load capacitance in the final stage, that is directly affected by the external capacitance, is relatively bigger. This also results from that, as described for the constant-bandwidth technology, in the three-stage source-follower amplifiers, the transconductance of the final-stage driver transistor is greater than the transconductance of the second-stage driver transistor, that is, the frequency bandwidth calculated by the equation (2) is greater than that of the two-stage source-follower amplifiers, as a result, the current consumptions can be reduced by the resulting extra currents.

Here, characteristics of the conventional semiconductor device 900 are examined. The gate widths and the gate lengths of the driver transistors are 8 $\mu$m and 4 $\mu$m in the initial stage, 80 $\mu$m and 4 $\mu$m in the second stage, and 800 $\mu$m and 4.5 $\mu$m in the final stage respectively, while the gate widths and the gate lengths of the load transistors are 10 $\mu$m and 26 $\mu$m in the initial stage, 110 $\mu$m and 10 $\mu$m in the second stage, and 150 $\mu$m and 10 $\mu$m in the final stage respectively.

When the gate bias voltage LG applied to the load transistors in the second and final stages varies from -5 V to 0 V, a linear region of input characteristics is shown in FIG. 2, the current consumption in the second stage is shown in FIG. 3, the current consumption in the final stage is shown in FIG. 4, and a frequency decreased by 3dB is shown in FIG. 5.

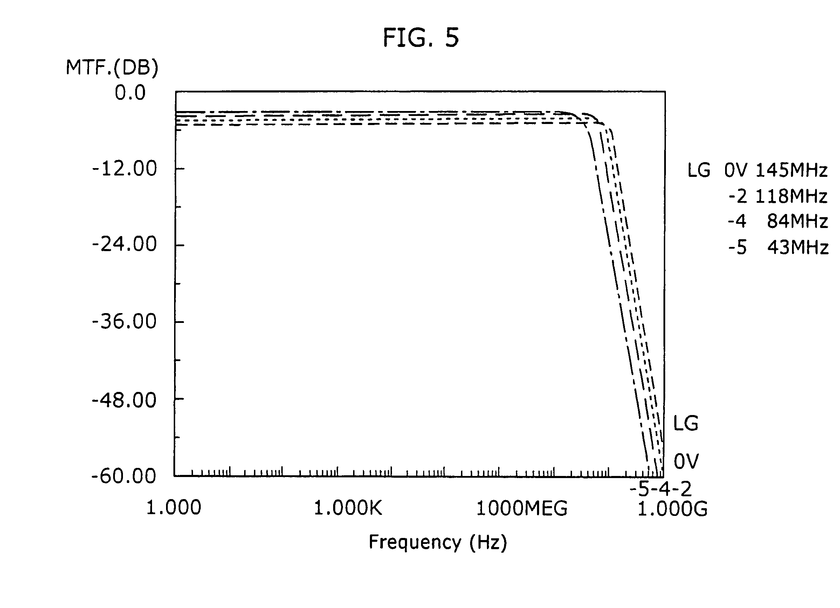

Referring to FIG. 5, the frequencies decreased by 3dB are 43MHz when the LG is -5V, and 145MHz when the LG is 0V respectively. In this case, the current consumptions are 1 mA and 10 mA respectively, and the gain and operating points vary within an acceptable range. Furthermore, the current consumption in the final stage is reduced from 5 mA to 1 mA in the same bandwidth as compared to the characteristics in the two-stage source-follower amplifiers.

However, there are two apparent problems with the conventional semiconductor device. As the first problem, in the case where the bias voltage applied to the gate of the load transistor in the latter source-follower amplifier is increased to expand the frequency bandwidth, the drain conductance of the load transistor increases unexpectedly and the current consumption increases, the operating points of the latter source-follower amplifier is lowered and the gain decreases.

Additionally, as the second problem, if the transconductance is lowered by way of only lowering the current of the load transistor in the latter source-follower amplifier to narrow the frequency bandwidth, the operating point is shifted, and a time imbalance between the leading edge and the trailing edge occurs owing to limit the effect entirely for the time of signal leading edge, eventually high-frequency component can not be removed completely.

## SUMMARY OF THE INVENTION

In view of the stated technical problems, it is a first object of the present invention to provide a semiconductor device which controls increase of current consumption and decrease of gain at the time of broad frequency bandwidth.

And also it is a second object of the present invention to provide a semiconductor device which reduces the imbalance between the time of leading edge and the time of trailing edge of signals.

The stated first object can be realized by the semiconductor device of the present invention, and the semiconductor of the present invention includes a source-follower amplifier having i) a plurality of driver transistors using sources as output, and ii) a load transistor connected to the plurality of driver transistors; and a first control circuit which makes the plurality of driver transistors operate selectively depending on a frequency bandwidth of an input signal inputted to the source-follower amplifier, characterized by the sources of the plurality of driver transistors being directly connected to each other.

As a result of using this device, actual gate width WD of the driver transistor is expanded by increasing the number of the driver transistor driving an input signal, accordingly the transconductance gmD of the driver transistor increases based on the equation (1). Here, in the case where the transconductance increases, the bandwidth frequency ft also increases based on the equation (2) as well. Thus, it is possible to expand the frequency bandwidth without increasing the electric current. And also in the case where the transconductance gmD of the driver transistor increases, the transconductance gmb of the back gate of the driver transistor, the conductance gdsD of the driver transistor D and the conductance gdsL of the load transistor L decrease relatively, as a result, the gain G increases based on the equation (4) and the characteristic of the source-follower amplifier can be improved.

The semiconductor device of the present invention can be characterized by that the first control circuit makes the plurality of driver transistors operate selectively depending on whether or not the input signal is inputted to each gate of the plurality of driver transistors.

In this way, expanding and narrowing the frequency bandwidth, and increasing and decreasing of gain can be realized by a simple configuration.

Furthermore the semiconductor device of the present invention can be characterized by that the gates of driver transistors are connected to each other, and the first control circuit makes the plurality of driver transistors operate selectively depending on whether or not a current between a drain and a source of each driver transistor is shut off.

In this way, expanding and narrowing the frequency bandwidth, and increasing and decreasing of gain can be realized by a simple configuration as well.

The semiconductor device of the present invention also may be characterized by that the first control circuit makes the plurality of driver transistors operate selectively depending on power voltage is supplied or output voltage of the source is supplied to a drain of each driver transistor.

The semiconductor device of the present invention also can be characterized by that the first control circuit includes a switching transistor connected between a drain and a source of each driver transistor, and makes the plurality of driver transistors operate selectively depending on whether or not the switching transistor is in a state of conduction.

The semiconductor device of the present invention can be characterized by that the first control circuit includes a switching transistor connected between a drain of each driver transistor and a power supply terminal, and makes the plurality of driver transistors operate selectively depending on whether or not the switching transistor is in a state of conduction.

The semiconductor device of the present invention is also characterized by that the load transistor includes a plurality of load transistors connected each other in parallel.

In this way, the variation of the operating point of the source-follower amplifier can be reduced. Moreover the value for the transconductance of each driver transistor and the complex transconductance of each load transistor to each driver transistor can be maintained in relatively big value, and the time of leading edge and the time of trailing edge of signal can be earlier. Hence the imbalance between the time of leading edge and the time of trailing edge can be reduced.

The semiconductor device of the present invention can be characterized by including a second control circuit which makes the plurality of load transistors operate selectively depending on frequency bandwidth of an input signal to said source-follower amplifier.

In this way, the operating point can be constant, and also the imbalance between the time of leading edge and the time of trailing edge can be reduced with simple configuration.

The semiconductor device of the present invention may be characterized by that the second control circuit makes the plurality of load transistors operate selectively depending on whether or not a current between a drain and a source of the plurality of load transistors is shut off.

It should be noted that the semiconductor device of the present invention can be included in a camera as a composition.

As described above, the semiconductor device according to the present invention is able to function effectively to expand the frequency bandwidth as well as to improve the gain without increasing electric current. This can be realized by the function that the first control circuit has the plurality of driver transistors operate selectively depending on the frequency bandwidth of input signal to the source-follower amplifier, as a result, the actual gate width W of driver transistor and the transconductance of driver transistor increase. And also as the plurality of load transistors connected to the driver transistors are available, the variation of operating point for the source-follower amplifier can be reduced. Moreover the value for the transconductance of each driver transistor and the complex transconductance of each load transistor to each driver transistor can be maintained in relatively big value, and the time of leading edge and the time of trailing edge of signal can be earlier. Hence the imbalance between the time of leading edge and the time of trailing edge can be reduced.

Accordingly, the present invention is providing the semiconductor device which enables to expand and reduce the frequency bandwidth, and also to increase and decrease current consumption effectively depending on in capturing still images or in capturing moving images, and the practical value of the present invention is extremely high under the circumstance of digital camera's popularization.

## BRIEF DESCRIPTION OF THE DRAWINGS

These and other objects, advantages and features of the invention will become apparent from the following description thereof taken in conjunction with the accompanying drawings that illustrate a specific embodiment of the invention. In the Drawings:

FIG. 1 shows a circuit diagram of a conventional semiconductor device.
FIG. 2 shows an output in the case where a bias voltage LG applied to a gate of a load transistors in a second and final stages in the semiconductor device 900 shown in FIG. 1 varies from -5 V to 0 V.

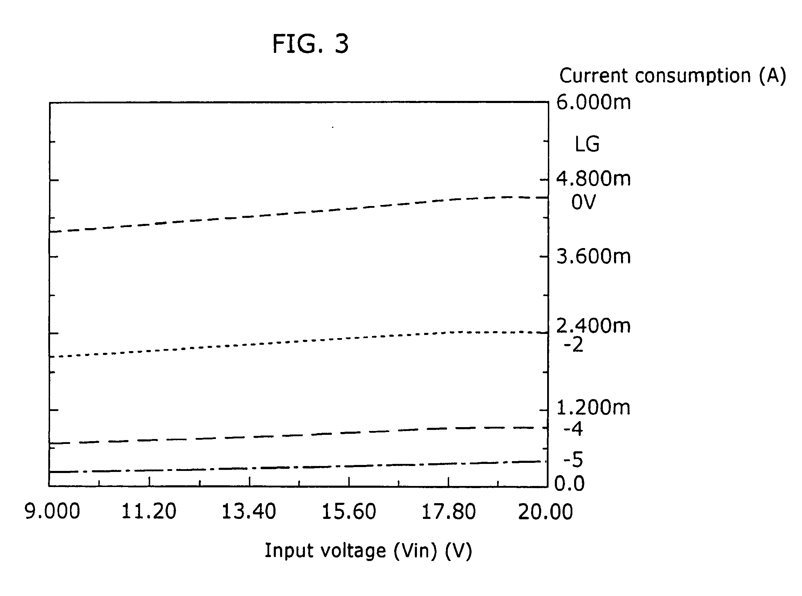

FIG. 3 shows a current consumption in the second stage in the semiconductor device 900 shown in FIG. 1.

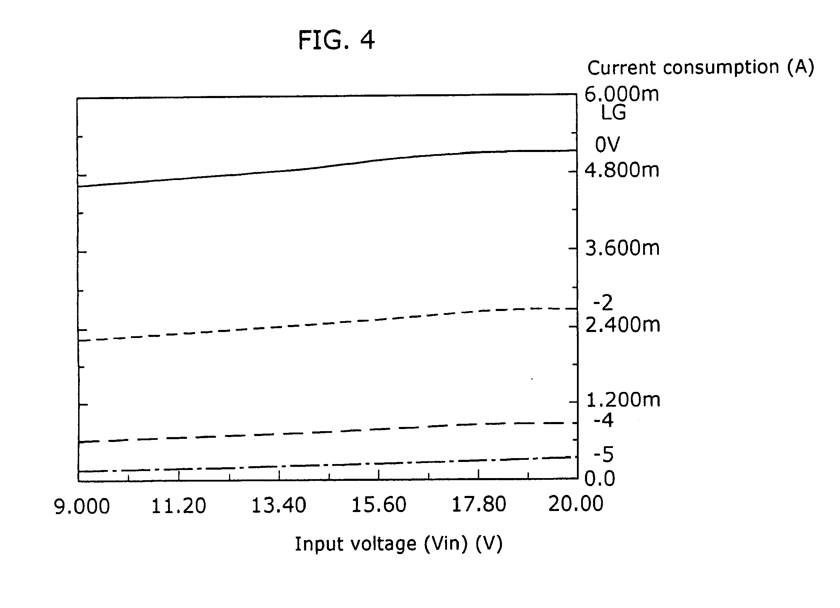

FIG. 4 shows the current consumption in the final stage in the semiconductor device 900 shown in FIG. 1.
FIG. 5 shows a frequency decreased by 3dB in the semiconductor device 900 shown in FIG. 1.

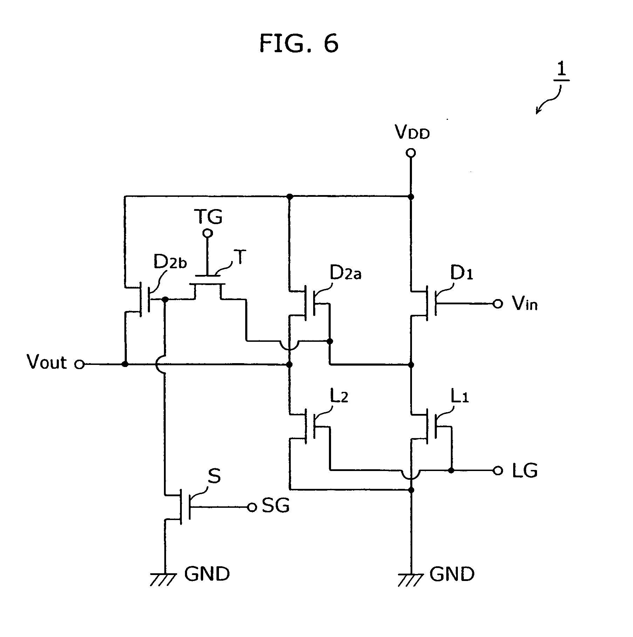

FIG. 6 shows a circuit diagram of the semiconductor device related to a first embodiment of the present invention.

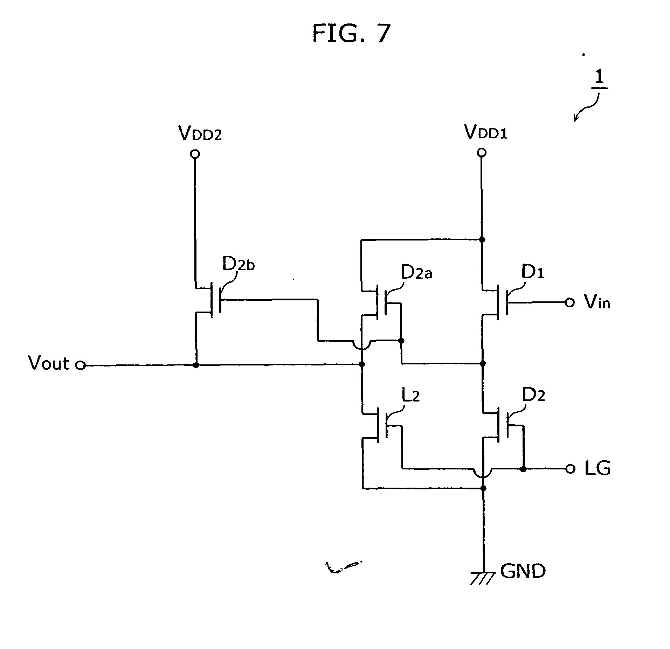

FIG. 7 shows a modified example of a circuit diagram controlling a driver transistor in a source-follower amplifier in a latter stage.

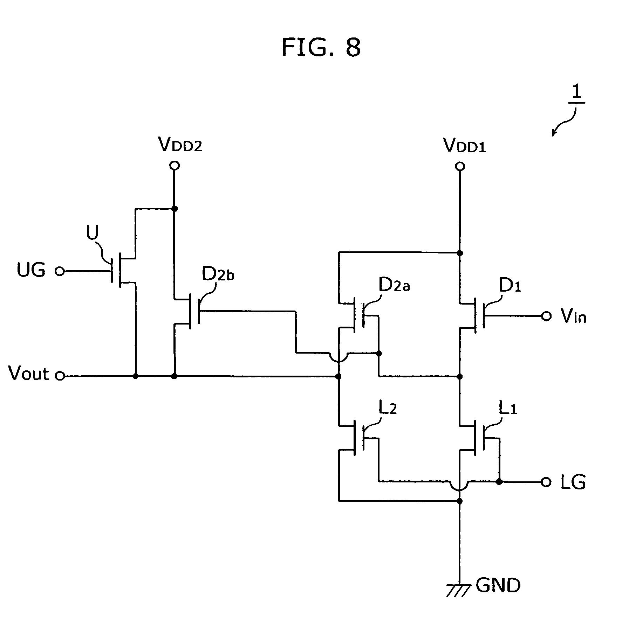

FIG. 8 shows another modified example of a circuit diagram controlling a driver transistor in a source-follower amplifier in a latter stage.

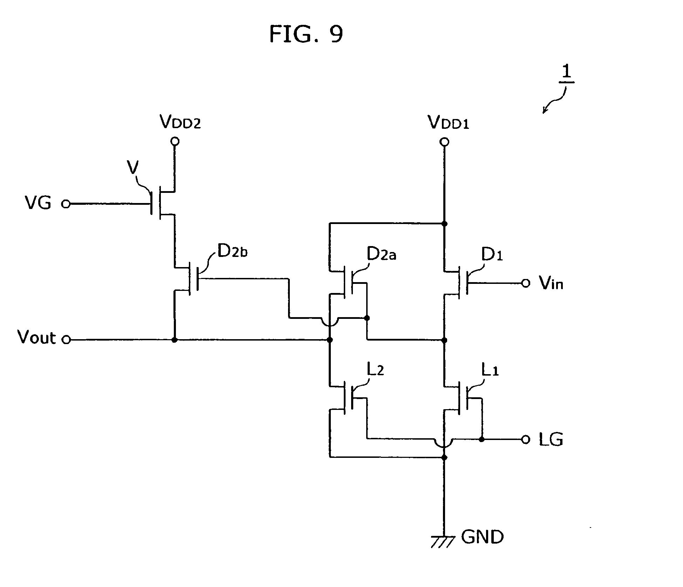

FIG. 9 shows another different modified example of a circuit diagram controlling a driver transistor in a source-follower amplifier in the latter stage.

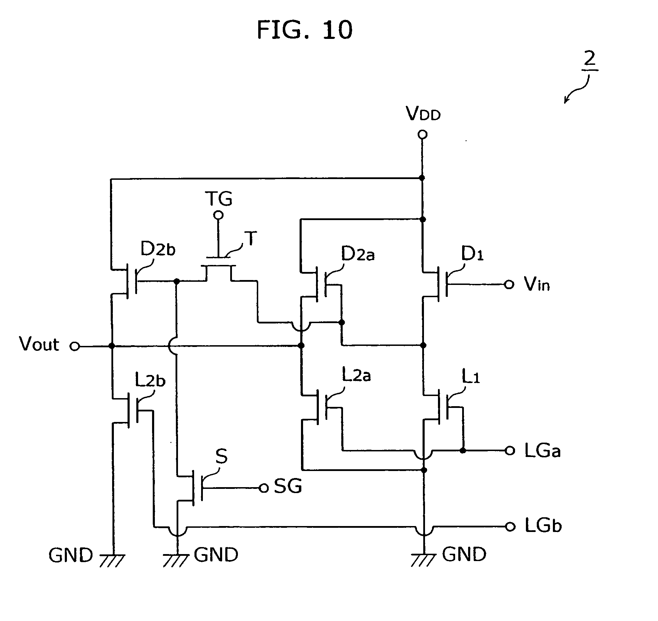

FIG. 10 shows a circuit diagram of the semiconductor device related to a second embodiment of the present invention.

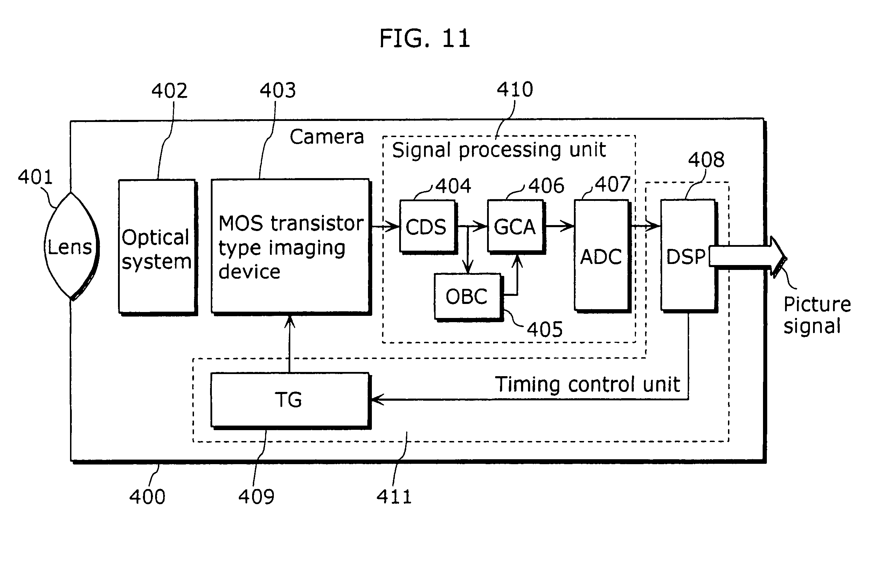

FIG.11 shows a configuration of a camera using the semiconductor devices of the first and second embodiments.

## DESCRIPTION OF THE PREFERRED EMBODIMENT(S)

Although only some exemplary embodiments of this invention have been described in detail above, those skilled in the art will readily appreciate that many modifications are possible in the exemplary embodiments without materially departing from the novel teachings and advantages of this invention.

The embodiment of the present invention will be described referring to drawings hereinafter.

[The first embodiment]

FIG. 6 shows a circuit diagram of the semiconductor device related to the first embodiment of the present invention. The same symbols are used as the conventional circuit diagram for the identical parts.

The semiconductor device in the first embodiment of the present invention is composed of two stages with source-follower amplifiers respectively as shown in FIG. 6.

The source-follower amplifier in the first stage (initial stage) includes a driver transistor D1 and a load transistor L1, and the source-follower amplifier in the second stage (final stage) includes plurality of driver transistors D2a and D2b (two in this drawing), a load transistor L2 and switching transistors S and T. It should be noted that the driver transistors D1 D2a and D2b, the load transistors L1 and L2 and the switching transistors S and T use MOS transistor.

The drains of the driver transistors D1, D2a and D2b in source-follower amplifiers in each stage are connected to a power supply terminal VDD, and also the load transistors L1 and L2 in the source-follower amplifiers in each stage are connected to a ground terminal GND respectively.

The source of the driver transistor D1 in the source-follower amplifier in the initial stage is connected to the drain of the load transistor L1, and also is connected to the gate of the driver transistor D2a in the source-follower amplifier in the second stage as well as to the gate of the driver transistor D2b through the switching transistor T. The gate of the driver transistor D1 is connected to the input terminal Vin for inputting pixel signals in capturing still images and moving images.

The sources of the driver transistors D2a and D2b in the source-follower amplifier in the second stage are connected to the drain of the load transistor L2, and are connected to the output terminal Vout respectively. The gate of the driver transistor D2b is grounded through the switching transistor S.

Additionally control signals SG and TG in high level or in the level of the load transistor are applied properly to the gates of the switching transistors T and S, and the power consumption and frequency bandwidth can be changed consecutively by driving the output of the source-follower amplifier in the initial stage by the driver transistor D2a solely or by the driver transistors D2a and D2b in parallel.

It should be noted that variable bias voltage LG can be applied to the gates of the load transistors L1 and L2 depending on the frequency bandwidth of inputted signals to the input terminal Vin, and the power consumption and the frequency bandwidth can be changed consecutively by the bias voltage LG actually, but in this description, suppose that the bias voltage is fixed.

In other words, the differences between the semiconductor device 1 and the conventional semiconductor device 900 are the number of the source-follower amplifiers is changed from three stages to two stages in the semiconductor device 1, and also as a key difference, the driver transistors of the source-follower amplifier in the final stage can be operated in parallel properly comparing to the case in the semiconductor device 900. It should be noted that the control signals SG and TG may be generated either outside or inside of the semiconductor device 1 and voltage is applied.

More specifically when still images are captured, by making the level of the control signal SG high and the level of the control signal TG low, the switching transistor T is shut off and the switching transistor S is conducted (in a state of conduction). Accordingly, in the source-follower amplifier in the latter stage, the operation of the driver transistor D2b is stopped, while only the driver transistor D2a is operated, and frequency bandwidth and current consumption of the source-follower amplifier in the second stage are decreased.

On the contrary, in the case where the frequency of pixel signal is increased in capturing moving images, by making the level of the control signal SG low and the level of the control signal TG high, the switching transistor T is conducted and the switching transistor S is shut off. Accordingly the driver transistors D2a and D2b are connected in parallel, and both driver transistors D2a and D2b drive the output of the source-follower amplifier in the initial stage.

In this way, the actual gate width WD of the driver transistor is expanded by increasing the number of the driver transistors driving input signals, and also transconductance gmD of the driver transistor is increased based on the equation (1). Here, when the transconductance is increased, the frequency bandwidth ft is increased based on the equation (2). As a result the frequency bandwidth can be expanded without increasing current. And also the transconductance gmD of the driver transistor increases, while the transconductance gmb on the back gate of the driver transistor D, the conductance gdsD of the driver transistor D and the conductance gdsL of the load transistor L get smaller relatively, and the gian G increases based on the equation (4). Consequently the characteristic of the source-follower amplifier can be improved.

Furthermore, expanding and narrowing the frequency bandwidth, and increasing and decreasing of gain can be realized by a simple configuration.

It should be noted that, in the first embodiment, the semiconductor device 1 is composed of source-follower amplifiers in two stages respectively, but the device 1 may be composed of a source-follower amplifier in one stage or be composed of source-follower amplifiers in more than three stages. In this case the source-follower amplifier may include plurality of driver transistors in either of the stages.

And also, in the first embodiment, only the source-follower amplifier in the latter stage includes plurality of driver transistors, but the source-follower amplifier in the initial stage may include plurality of driver transistors. In other words, the source-follower amplifier in all of the stages may include plurality of driver transistors.

And also, in the first embodiment, the source-follower amplifier in the latter stage includes two of driver transistors, but the source-follower amplifier may include more than three of driver transistors.

And also, in the first embodiment, the description is shown supposing that the bias voltage LG is fixed, but the bias voltage LG applied to the gates may be variable individually or in common to change frequency bandwidth and current consumption. In this case the bias voltage LG may be generated either outside or inside of the semiconductor device 1 and voltage is applied.

Furthermore, in the first embodiment, the switching transistor T is placed between the gates of the driver transistor D2a and the driver transistor D2b, and the switching transistor T is placed between the ground terminal GND and the gate of the driver transistor D2b, and only the driver transistor D2a is activated, or alternatively both the driver transistor D2a and D2b are activated in the source-follower amplifier in the final stage by turning on and off the switching transistors S and T. In other words, plurality of driver transistors can function selectively depending on whether input signal is inputted to the each gate of the driver transistors. As another configuration, only the driver transistor D2a is activated, or alternatively both the driver transistors D2a and D2b are activated in the source-follower amplifier in the final stage. More specifically plurality of driver transistors may function selectively depending on whether the current between drain and source of each driver transistor is shut off.

For example as shown in FIG. 7, the switching transistors S and T may be removed, the sources of the driver transistors D1 and D2a are connected to power supply terminal VDD1 and the source of the driver transistor D2b may be connected to another power supply terminal VDD2. By supplying voltage VDD to power supply terminal VDD2, both driver transistors D2a and D2b of the source-follower amplifier in the final stage are activated. By applying voltage which amount is same as output Vout to the power supply terminal VDD2, the driver transistor D2b is shut off and only the driver transistor D2a in the source-follower amplifier in the final stage may be activated. In this case, as shown in FIG. 8, a switching transistor U may be placed between drain and source of the driver transistor D2b, and the driver transistor D2b may be activated by turning off the switching transistor U, or the driver transistor D2b may be inactivated by turning on the switching transistor U.

Besides, as shown in FIG. 9, the switching transistor V may be placed between power voltage supply terminal VDD2 and drain of the driver transistor D2, and the driver transistor D2b may be activated by supplying power voltage VDD by turning on the switching transistor V, or the driver transistor D2b may be inactivated by shutting off power voltage VDD by turning off the switching transistor V.

[The second embodiment]

The semiconductor device related to the second embodiment of the present invention will be described hereinafter.

FIG. 10 shows a circuit diagram of the semiconductor device related to the second embodiment of the present invention. It should be noted that the same numbers are used as the example of the conventional semiconductor device and the first embodiment for the identical parts.

The difference between the semiconductor device 2 of the second embodiment and the semiconductor device 1 of the first embodiment is plurality of load transistors (two in the figure) in the source-follower amplifier in the second stage are included. More specifically, the load transistor in the source-follower amplifier in the second stage (the final stage) is composed of the load transistor L2a and the load transistor L2b connected to L2a in parallel.

In fact, as shown in FIG. 10, the semiconductor device 2 is composed of source-follower amplifiers in two stages respectively, and the driver transistor L2b connected in parallel to the driver transistor L2a in the source-follower amplifier in the second stage.

The source-follower amplifier in the first stage (initial stage) includes a driver transistor D1 and a load transistor L1, and the source-follower amplifier in the second stage includes a driver transistors D2, load transistors L2a and L2b and switching transistors S and T. It should be noted that the driver transistors D1, D2a and D2b, the load transistors L1 L2a and L2b and the switching transistors S and T use MOS transistor.

The drains of the driver transistors D1, D2a and D2b in source-follower amplifiers in each stage are connected to a power supply terminal VDD, and also the load transistors L1, L2a and L2b in the source-follower amplifiers in each stage are connected to a ground terminal GND respectively.

The source of the driver transistor D1 in the source-follower amplifier in the initial stage is connected to the drain of the load transistor L1, and also is connected to the gate of the driver transistor D2a in the source-follower amplifier in the second stage as well as to the gate of the driver transistor D2b through the switching transistor T. The gate of the driver transistor D1 is connected to the input terminal Vin for inputting pixel signals in capturing moving images and still images.

The sources of the driver transistors D2a and D2b in the source-follower amplifier in the second stage are connected to the drains of the load transistors L2a and L2b respectively, and are connected to the output terminal Vout respectively from which the pixel signal is outputted to outside. The gate of the driver transistor D2b is grounded through the switching transistor S.

Additionally control signals SG and TG in high level or low level are applied properly to the gates of the switching transistors T and S, and the power consumption and frequency bandwidth can be changed consecutively by driving the output of the source-follower amplifier in the initial stage by the driver transistor D2 solely or by the driver transistors D2a and D2b in parallel.

It should be noted that variable bias voltage LGa and LGb can be applied individually to the gates of the load transistors L1, L2a and L2b depending on the frequency bandwidth of inputted signals to the input terminal Vin, and the power consumption and the frequency bandwidth can be changed consecutively by the bias voltage LGa and LGb actually, but in this description, suppose the bias voltage is fixed.

In other words, the differences between the semiconductor device 2 and the conventional semiconductor device 900 are the number of the source-follower amplifiers is changed from three stages to two stages in the semiconductor device 2, and also as a key difference, the driver transistors can be operated in parallel properly and also the load transistors can be operated in parallel in the source-follower amplifier in the final stage comparing to the case in the semiconductor device 900. It should be noted that the control signals SG and TG may be generated either outside or inside of the semiconductor device 2 and voltage is applied.

More specifically when still images are captured, by making adjustments of the level of the control signal SG to high and the level of the control signal TG to low, the switching transistor T is shut off and the switching transistor S is conducted. Accordingly, in the source-follower amplifier in the latter stage, the operation of the driver transistor D2b is stopped, while only the driver transistor D2a is activated, and frequency bandwidth and current consumption of the source-follower amplifier in the second stage are decreased. At this time, the load transistors L2a and L2b are operating in parallel.

On the contrary, in the case where the frequency of pixel signal is increased in capturing moving images, by making adjustments of the level of the control signal SG to low and the level of the control signal to high, the switching transistor T is conducted and the switching transistor S is shut off. Accordingly the driver transistors D2a and D2b are connected in parallel, and both driver transistors D2a and D2b drive the output of the source-follower amplifier in the initial stage. At this time, the load transistors L2a and L2b are operating in parallel.

In this way, the actual gate width WD of the driver transistor is expanded by increasing the number of the driver transistor driving input signals, and also transconductance gmD of the driver transistor is increased based on the equation (1). Here, when the transconductance increases, frequency bandwidth ft increases based on the equation (2). As a result the frequency bandwidth can be expanded without increasing current. And also transconductance gmD of the driver transistor increases, while transconductance gmb on the back gate of the driver transistor D, conductance gdsD of the driver transistor D and conductance gdsL of the load transistor L get smaller relatively, and the gain G increases based on the equation (4). Consequently the characteristic of the source-follower amplifier can be improved.

Since the load transistors are operating in parallel, the variation of the operating point in the source-follower amplifier can be reduced. Moreover the value for the transconductance of each driver transistor and the complex transconductance of each load transistor to each driver transistor can be maintained in relatively big value, and the time of leading edge and the time of trailing edge of signal can be earlier. Hence the imbalance between the time of leading edge and the time of trailing edge can be reduced.

It should be noted that, in the second embodiment, the semiconductor device 2 is composed of source-follower amplifiers in two stages respectively, but the device 2 may be composed of a source-follower amplifier in one stage only or be composed of source-follower amplifiers in more than three stages respectively. In this case the source-follower amplifier can include plurality of driver transistors and load transistors in either of the stages.

And also, in the second embodiment, only the source-follower amplifier in the latter stage includes plurality of driver transistors and load transistors, but the source-follower amplifier in the initial stage may include plurality of driver transistors and load transistors. In other words, the source-follower amplifier in all of the stages may include plurality of driver transistors and load transistors.

And also, in the second embodiment, the source-follower amplifier in the latter stage includes two of driver transistors and load transistors, but the source-follower amplifier may include more than three of driver transistors and load transistors.

And also, in the second embodiment, the description is shown supposing that the bias voltage LGa and LGb are fixed, but the bias voltage LGa and LGb applied to the gates may be variable individually or in common to change frequency bandwidth and current consumption. In this case the bias voltage LGa and LGb may be generated either outside or inside of the semiconductor device 2 and voltage is applied.

Furthermore, in the second embodiments, the load transistors L2a and L2b are constantly operated in parallel. Or alternatively, the load transistors L2a and L2b may be operated in parallel in line with operation of the driver transistors D2a and D2b, or a control circuit may be included to make the load transistor L2a operate solely. In other words, the second control circuit may be included to make plurality of load transistors function selectively depending on frequency bandwidth of a input signal to the source-follower amplifier. In this way, it is possible to maintain a constant operating point, and to reduce the imbalance between the time of leading edge and the time of trailing edge with a simple configuration.

In this case, the second control circuit can be configured to make the plurality of load transistors operate selectively depending on whether the current between drain and source in plurality of load transistors are shut off. More particularly, for example, the second control circuit may be configured by a switching transistor being placed between output terminal Vout and drain of the load transistor L2a, conducting by signal in high level, and shutting off by the signal in low level.

It should be noted that the above-mentioned semiconductor devices 1 and 2 may be mounted in an electronic part of such as imaging device, and a camera may include the electronic part so as to realize the same operation and effect as the semiconductor devices 1 and 2.

FIG. 11 shows a configuration of a camera using the semiconductor devices of the first and second embodiments.

As shown in FIG. 11, a camera 400 consists of a lens 401 for imaging an optical image of an object to imaging device, an optical system 402 such as a mirror and a shutter for optical processing of optical image transmitted through the lens 401, a MOS transistor type imaging device 403 equipping above-mentioned semiconductor device, a signal processing unit 410, a timing control unit 411 and so on. The timing control unit 411 consists of a CDS circuit 404 taking a difference between signals of fieldthrough outputted from MOS transistor type imaging device 403 and outputting signals, an OB clamping circuit 405 for detecting OB level signal outputted from CDS circuit 404, a GCA406 for adjusting a gain which is a difference of signal levels between OB levels and effective pixels, an ADC407 for converting analog signal outputted from GCA406 into digital signal and so on. The timing control unit 411 performs signal processing to digital signal outputted from ADC407, and also the unit 411 consists of a DSP408 for controlling driving timing and a TG409 for generating various driving pulses at various timings to MOS transistor type imaging device 403 according to the direction by DSP408 and so on.

With the camera 400 configured like above, it is possible to realize a camera expanding the bandwidth without increasing current in capturing moving images, moreover narrowing the bandwidth and improving the amplification factor in capturing still images by MOS transistor type imaging device 403 equipped with the above-mentioned semiconductor device.

Note that it is exemplified about a case where MOS transistor type as imaging device is used in this embodiment, yet CCD type may be used as well.

**INDUSTRIAL APPLICABILITY**

The present invention is suitable for a semiconductor device equipped with a source-follower amplifier, and a camera equipped with the semiconductor device, for example suitable for such as an image sensor, a digital still camera, a camera-equipped cellular phone, a camera installed in a laptop computer and a camera unit connected to information processor.

**Claims**

1. A semiconductor device, comprising:

a source-follower amplifier including i) a plurality of driver transistors ($D_{2a}$, $D_{2b}$) using sources as output and ii) a load transistor ($L_2$) connected to the plurality of driver transistors; and

a first control circuit (SG,TG) operable to make the plurality of driver transistors operate selectively depending on a frequency bandwidth of an input signal inputted to the source-follower amplifier, **characterized by** the sources of the plurality of driver transistors being directly to each other.

2. The semiconductor device according to Claim 1,
wherein said first control circuit is operable to make the plurality of driver transistors operate selectively depending on whether or not the input signal is inputted to each gate of the plurality of driver transistors.

3. The semiconductor device according to Claim 1,
wherein gates of driver transistors are connected to each other,
said first control circuit is operable to make the plurality of driver transistors operate selectively depending on whether or not a current between a drain and a source of each driver transistor is shut off.

4. The semiconductor device according to Claim 3,
wherein said first control circuit is operable to make the plurality of driver transistors operate selectively depending on power voltage is supplied or output voltage of the source is supplied to a drain of each driver transistor.

5. The semiconductor device according to Claim 3,
wherein said first control circuit includes a switching transistor connected between a drain and a source of each driver transistor, and is operable to make the plurality of driver transistors operate selectively depending on whether or not the switching transistor is in a state of conduction.

6. The semiconductor device according to Claim 3,
wherein said first control circuit includes a switching transistor connected between a drain of each driver transistor and a power supply terminal, and is operable to make the plurality of driver transistors operate selectively depending on whether or not the switching transistor is in a state of conduction.

7. The semiconductor device according to Claim 1,
wherein the load transistor includes a plurality of load transistors connected each other in parallel.

8. The semiconductor device according to Claim 7, comprising
a second control circuit operable to make the plurality of load transistors operate selectively depending on frequency bandwidth of an input signal to said source-follower amplifier.

9. The semiconductor device according to Claim 8,
wherein said second control circuit is operable to make the plurality of load transistors operate selectively depending on whether or not a current between a drain and a source of the plurality of load transistors is shut off.

10. A camera, comprising
a semiconductor device according to one of Claim 1 to Claim 9.

**Patentansprüche**

1. Halbleiteranordnung mit:

einem Sourcefolgerverstärker mit I) mehreren Treibertransistoren ($D_{2a}$, $D_{2b}$), die Sources als Ausgang verwenden, und II) einem Lasttransistor ($L_2$), der mit den mehreren Treibertransistoren verbunden ist; und
einer ersten Steuerschaltung (SG, TG), die so betreibbar ist, dass sie die mehreren Treibertransistoren selektiv in Abhängigkeit von einer Frequenzbandbreite eines in den Sourcefolgerverstärker eingegebenen Eingangssignals arbeiten lässt,

**dadurch gekennzeichnet, dass** die Sources der mehreren Treibertransistoren direkt miteinander verbunden sind.

2. Halbleiteranordnung nach Anspruch 1, **dadurch gekennzeichnet, dass** die erste Steuerschaltung so betreibbar ist, dass sie die mehreren Treibertransistoren selektiv in Abhängigkeit davon arbeiten lässt, ob das Eingangssignal in jedes Gate der mehreren Treibertransistoren eingegeben wird oder nicht.

3.  Halbleiteranordnung nach Anspruch 1, **dadurch gekennzeichnet, dass**
    Gates von Treibertransistoren miteinander verbunden sind und
    die erste Steuerschaltung so betreibbar ist, dass sie die mehreren Treibertransistoren selektiv in Abhängigkeit davon arbeiten lässt, ob ein Strom zwischen einem Drain und einer Source jedes Treibertransistors abgeschaltet wird oder nicht.

4.  Halbleiteranordnung nach Anspruch 3, **dadurch gekennzeichnet, dass** die erste Steuerschaltung so betreibbar ist, dass sie die mehreren Treibertransistoren selektiv in Abhängigkeit davon arbeiten lässt, dass eine Leistungsspannung oder eine Ausgangsspannung der Source in einen Drain jedes Treibertransistors eingespeist wird.

5.  Halbleiteranordnung nach Anspruch 3, **dadurch gekennzeichnet, dass** die erste Steuerschaltung einen Schalttransistor, der zwischen einen Drain und eine Source jedes Treibertransistors geschaltet ist, aufweist und so betreibbar ist, dass sie die mehreren Treibertransistoren selektiv in Abhängigkeit davon arbeiten lässt, ob der Schalttransistor in einem Leitungszustand ist oder nicht.

6.  Halbleiteranordnung nach Anspruch 3, **dadurch gekennzeichnet, dass** die erste Steuerschaltung einen Schalttransistor, der zwischen einen Drain jedes Treibertransistors und einen Stromversorgungsanschluss geschaltet ist, aufweist und so betreibbar ist, dass sie die mehreren Treibertransistoren selektiv in Abhängigkeit davon arbeiten lässt, ob der Schalttransistor in einem Leitungszustand ist oder nicht.

7.  Halbleiteranordnung nach Anspruch 1, **dadurch gekennzeichnet, dass** der Lasttransistor mehrere miteinander parallelgeschaltete Lasttransistoren aufweist.

8.  Halbleiteranordnung nach Anspruch 7 mit einer zweiten Steuerschaltung, die so betreibbar ist, dass sie die mehreren Lasttransistoren selektiv in Abhängigkeit von einer Frequenzbandbreite eines in den Sourcefolgerverstärker eingegebenen Eingangssignals arbeiten lässt.

9.  Halbleiteranordnung nach Anspruch 8, **dadurch gekennzeichnet, dass** die zweite Steuerschaltung so betreibbar ist, dass sie die mehreren Lasttransistoren selektiv in Abhängigkeit davon arbeiten lässt, ob ein Strom zwischen einem Drain und einer Source der mehreren Lasttransistoren abgeschaltet wird oder nicht.

10. Kamera mit einer Halbleiteranordnung nach einem der Ansprüche 1 bis 9.

**Revendications**

1.  Dispositif semi-conducteur comprenant :

    un amplificateur à source chargée incluant 1) une pluralité de transistors pilotes (D2a et D2b) utilisant les sources comme sortie et 2) un transistor de charge (L2) relié à la pluralité de transistors pilotes ; et
    un premier circuit de commande (SG et TG) utilisable pour permettre à la pluralité de transistors pilotes de fonctionner de manière sélective, par rapport à une bande passante de fréquence d'un signal d'entrée entré dans l'amplificateur à source chargée, **caractérisé par** les sources de la pluralité de transistors pilotes étant directement reliés entre elles.

2.  Dispositif semi-conducteur selon la revendication 1,
    dans lequel ledit premier circuit de commande est utilisable pour permettre à la pluralité de transistors pilotes de fonctionner de manière sélective, selon que le signal d'entrée est entré à chaque portillon de la pluralité de transistors pilotes ou non.

3.  Dispositif semi-conducteur selon la revendication 1,
    dans lequel les portillons des transistors sont reliés entre eux,
    ledit premier circuit de commande est utilisable pour permettre à la pluralité de transistors pilotes de fonctionner de manière sélective, selon qu'un courant entre un drain et une source de chaque transistor pilote est coupé ou non.

4.  Dispositif semi-conducteur selon la revendication 3,

dans lequel ledit premier circuit de commande est utilisable pour permettre à la pluralité de transistors pilotes de fonctionner de manière sélective, selon que la tension d'énergie est fournie ou que la tension de sortie de la source est fournie à un drain de chaque transistor pilote.

5. Dispositif semi-conducteur selon la revendication 3,
dans lequel ledit premier circuit de commande inclut un transistor de commutation connecté entre un drain et une source de chaque transistor pilote et est utilisable pour permettre à la pluralité de transistors pilotes de fonctionner de manière sélective, selon que le transistor de commutation est dans un état de conduction ou non.

6. Dispositif semi-conducteur selon la revendication 3,
dans lequel ledit premier circuit de commande inclut un transistor de commutation connecté entre un drain de chaque transistor pilote et un terminal de fourniture d'énergie, et est utilisable pour permettre à la pluralité de transistors pilotes de fonctionner de manière sélective, selon que le transistor de commutation est dans un état de conduction ou non.

7. Dispositif semi-conducteur selon la revendication 1,
dans lequel le transistor de charge inclut une pluralité de transistors de charge reliés entre eux en parallèle.

8. Dispositif semi-conducteur selon la revendication 7, comprenant
un deuxième circuit de commande utilisable pour permettre à la pluralité de transistors de charge de fonctionner de manière sélective, par rapport à une bande passante de fréquence d'un signal d'entrée audit amplificateur à source chargée.

9. Dispositif semi-conducteur selon la revendication 8,
dans lequel ledit deuxième circuit de commande est utilisable pour permettre à la pluralité de transistors de charge de fonctionner de manière sélective, selon qu'un courant entre un drain et une source de la pluralité de transistors de charge est coupé ou non.

10. Caméra, comprenant
un dispositif semi-conducteur selon l'une des revendications 1 à 9.

# FIG. 1

# FIG. 2

Output voltage
(V) (Vout)

EP 1 622 261 B1

# FIG. 3

Current consumption (A)

Input voltage (Vin) (V)

EP 1 622 261 B1

# FIG. 4

Current consumption (A)

Input voltage (Vin) (V)

EP 1 622 261 B1

FIG. 5

MTF.(DB)

# FIG. 6

# FIG. 7

# FIG. 8

# FIG. 9

# FIG. 10

# FIG. 11

EP 1 622 261 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2795314 B